Europäisches Patentamt

European Patent Office

Office européen des brevets

(11) Publication number: **0 130 412**
**B1**

# (12) EUROPEAN PATENT SPECIFICATION

(45) Date of publication of patent specification: **03.02.88**

(51) Int. Cl.⁴: **H 01 L 27/06**

(21) Application number: **84106503.0**

(22) Date of filing: **07.06.84**

(54) Semiconductor device having a protection circuit.

(30) Priority: **30.06.83 JP 119083/83**

(43) Date of publication of application:
**09.01.85 Bulletin 85/02**

(45) Publication of the grant of the patent:
**03.02.88 Bulletin 88/05**

(84) Designated Contracting States:
**DE FR GB**

(56) References cited:
**EP-A-0 055 552**
**EP-A-0 058 557**
**DE-A-2 722 892**
**US-A-3 754 171**
**US-A-4 062 039**

(73) Proprietor: **FUJITSU LIMITED**
**1015, Kamikodanaka Nakahara-ku**
**Kawasaki-shi Kanagawa 211 (JP)**

(72) Inventor: **Shirato, Takehide**
**6-26, Sengencho**
**Hiratsuka-shi Kanagawa, 254 (JP)**

(74) Representative: **Seeger, Wolfgang, Dipl.-Phys.**
**European Patent Attorney Bereiteranger 15**
**D-8000 München 90 (DE)**

Courier Press, Leamington Spa, England.

# 0 130 412

**Description**

The present invention relates to a semiconductor device having a protection circuit to prevent the device from the destruction due to excess voltage induced by electric surge or pulse noise. Especially it relates to the protection circuit having a higher ability to withstand the excess input voltage and still providing the inner elements of the device to be protected with suitable low protection voltage.

In a semiconductor device, to improve its reliability, a protection circuit having protective elements such as semiconductor diodes is formed together with the inner elements such as MOS FETs on the semiconductor substrate. The protection circuit prevents inner elements from destruction due to high voltage derived from an external pulse noise or charged human body or the like. As the ICs (integrated circuits) such as memory ICs make a remarkable progress in integration and high speed information processing ability, the structure of the elements formed in the IC becomes fine and delicate.

Especially, an insulating layer under the gate electrode of MOS FET (metal oxide semiconductor type field effect transistor) formed in the device is so thin that it is often broken down by the applied electric field formed by a relatively small amount of electric charge supplied by the outer source such as charged human body.

In addition, the size and depth of impurity regions of the inner elements has been becoming smaller with the progress above mentioned. This tends further to reduce the strength of the protective elements formed in the device to the excess voltage.

The impurity region of elements of a semiconductor device is usually formed by diffusing impurity material (dopant) to a specified region in a substrate, so this will be called 'diffusion region' hereafter. The protection circuit elements have also diffusion regions which are formed at the same diffusion process for forming the inner elements, so the depth of the diffusion region for the protection elements became shallow and small together with that of the inner elements.

Generally, in reverse-biased semiconductor rectifiers, such as diodes or diode-connected transistors or the like, the breakdown voltage decreases as the depth of diffusion region becomes shallow. The breakdown voltage is defined as a voltage at which a reverse-biased p-n junction ceases to have sufficient impedance. Usually, the impurity region formed by a thermal diffusion process, has a side wall with a radius of curvature $r_i$ when the side wall is seen on its cut view. This radius $r_i$ is almost equal to the diffusion depth. So the deeper diffusion region has a larger radius of the curvature along the boundary of the region. The large radius relaxes the concentration of electric field resulting in increasing breakdown voltage of the element.

When the reverse current at the breakdown voltage exceeds a critical value, the junction of the diode will be melted and damaged locally at a portion where the current concentrates. The energy initiating the damage of the junction shall be defined as the burn out energy of the diode, and will be called simply 'burn out energy' hereinafter. The large radius of the curvature $r_i$ of the side wall of the diffusion region also decreases the concentration of the diode current resulting in relatively uniform distribution of heat generation at the junction. Therefore the burn out energy increases with the depth of the diffusion region.

The surge capacity is defined as the ability of a diode to withstand the voltage or current transients in excess of its normal rating. The surge capacity is influenced by many factors, but the burn out energy plays a main roll. So, increasing the burnout energy will be regarded equivalent for improving the surge capacity of the protective elements.

From this point of view, a semiconductor device having protection elements having a deeper diffusion region than that of inner elements was proposed by T. Yamanaka in Tokugan SH055—11864 to the Japanese Patent Office in 1980. In this proposal, the elements in the protection circuit of the device are expected to have a higher burn-out energy and an increased surge capacity. But, by doing so, the breakdown voltage itself goes up as stated above. This is not desirable for protecting the inner elements of the device, since the higher voltage appears to the inner elements as the breakdown voltage of the protective element goes up.

As stated before, the depth of the diffusion region of the protective elements is required to be thinner to provide the lower protection voltage. Such a device is known from US—A—3754171. This means that there are conflicting requirements for a protective element of the protection circuit between realizing the higher surge capacity and reducing the protection voltage at the same time. Therefore, the prior art protective elements according to the above proposal are becoming unsatisfactory for the protection circuit.

In the output circuit, usually semiconductor elements for large output are contained, and generally, the output terminals are connected to the diffusion region of such large elements, so the elements themselves act as a protective diodes. Therefore no special protection circuits has been arranged for the output circuit. In addition, in the output circuit, a diffusion region for a resistor is not inserted in order to avoid the reduction of the output level. But in a high output voltage circuit such as the one for a driving circuit for fluorescent display tubes, some protecting means for inner elements becomes necessary.

Recently, input/output terminals are used frequently in an one-chip microcomputer or other IC devices. In such a device, the protection circuit for the output circuit is also necessary in order to secure the reliability of the IC device.

And some improvement of the prior art protection circuit has been expected to solve this problem.

2

## Summary of the invention

It is an object of the present invention to provide a semiconductor device having highly integrated inner elements such as MOS FET with an improved protection circuit.

Another object of the present invention is to provide a semiconductor device with a protection circuit for inner elements, having a lower protection voltage enough to protect the inner elements and higher surge capacity (burn out energy) enough to withstand the relatively high energy input such as electrical surge, electric-static charge of a human body and so on.

The foregoing objects are attained by the subject matter of claim 1 in which a protection circuit is formed in a conventional semiconductor device such as IC memory having inner elements, metal-oxide-semiconductor field effect transistors (MOS FETs) for example. The protection circuit comprises elements of two types; the first one having a relatively deep diffusion region to provide a higher surge capacity to withstand high pulse current and the other one having relatively shallow diffusion region equal to or shallower than that of the inner elements to provide a low protection voltage enough to protect the inner elements.

In the IC device, the input, output or input/output terminal, the first type protective element, second type protective element and the inner elements to be protected are positioned in series in the recited order. Usually, the protective elements are composed of a junction diode and a lateral transistor, which are connected electrically so as to by-pass the excess voltage applied to the terminal of the device to the ground by the protective elements.

Electric charge or an electrical surge applied to the terminal of the device, usually has a pulse form of short duration. It will charge up and raise the reverse voltage to the first type protection circuit element, but the raising voltage is clamped by the breakdown of the diode, discharging the most part of the input electrical charge to the ground. The burn out energy of the first type diode is large enough to withstand the input energy applied to the diode, resulting in no burn out destruction of the diode.

Generally, the first protective element (diode) and the adjacent wiring have parasitic capacity. And the terminal is connected at one point of the diffusion region of the first protective element, and the another point of the diffusion region is connected to the collector terminal of the second protection diode, the lateral transistor. So the diffusion region works as a resistor between the terminal and the collector of the lateral transistor. The parasitic capacity and the resistivity of the diffusion region form a C—R network, which reduces the peak voltage and provides a time delay of the shock to the second protective element. During this time delay, most part of applied pulse energy is discharged and the current applied to the second protective elements decreases. This prevents the second protective elements from destructive burning out.

A diffusion region provided with two separate contact points working as a resistor between a terminal and an insulated gate type field effect transistor is known from US—A—3 754 171. As a result of the capacitance of the pn junction formed between the diffusion region and the substrate, a low pass RC filter is connected to the input circuit yielding a function of suppressing a surge voltage having a large peak value.

Thus the excess pulse voltage applied to the terminal of the IC device is discharged by the first protective element and is clamped to a specified low voltage by the second protective element, while the protection circuit has a strong withstanding ability to the excess incoming pulse energy, resulting in the enhancement of the reliability of the device.

Now concrete preferred embodiments according to the present invention will be described hereunder referring to the accompanying drawings.

## Brief description of the drawings

Fig. 1 illustrates schematically a plan view of a semiconductor device (IC) according to the present invention.

Fig. 2 illustrates schematically a cross-sectional view of the semiconductor device (IC) shown in Fig. 1.

Fig. 3 illustrates schematically the cross-sectional structure of a semiconductor shown in Fig. 1, corresponding to a particular step of the fabrication process.

Fig. 3(a) illustrates a partial structure of the IC device after the field oxide layer and channel cut has been formed.

Fig. 3(b) illustrates a partial structure of the IC device after the gate oxide layer has been formed.

Fig. 3(c) illustrates a partial structure of the IC device after the gate electrode of the FET has been formed.

Fig. 3(d) illustrates a partial structure of the IC device after the photo-resist layer has been formed and the dopant ions for the diffusion region of the first protective element has been implanted.

Fig. 3(e) illustrates a partial structure of the IC device after the formation of phospho-silicate glass layer.

Fig. 3(f) illustrates a partial structure of the IC device after the aluminum interconnecting layer has been patterned to form the circuit wiring.

## Description of the preferred embodiments

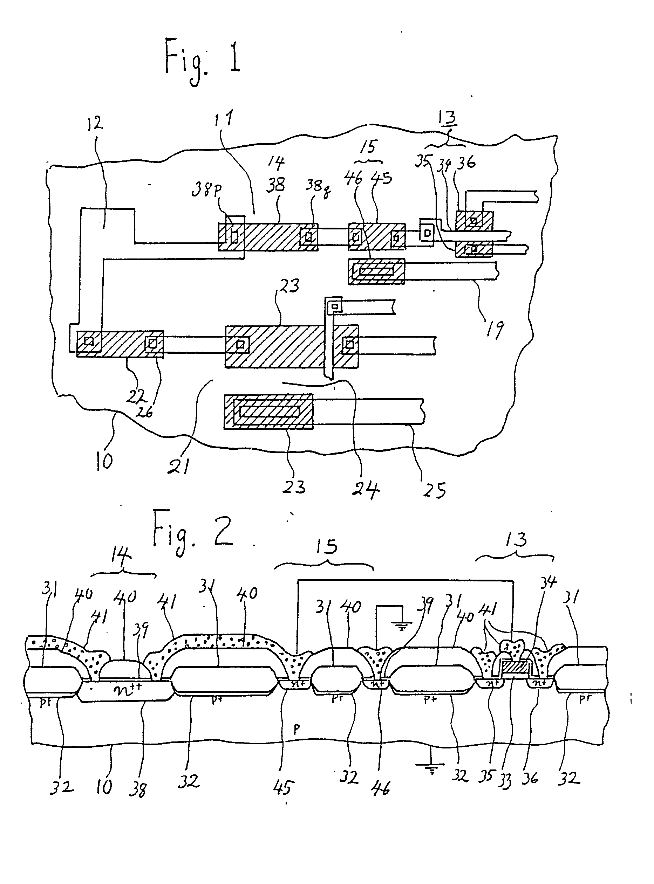

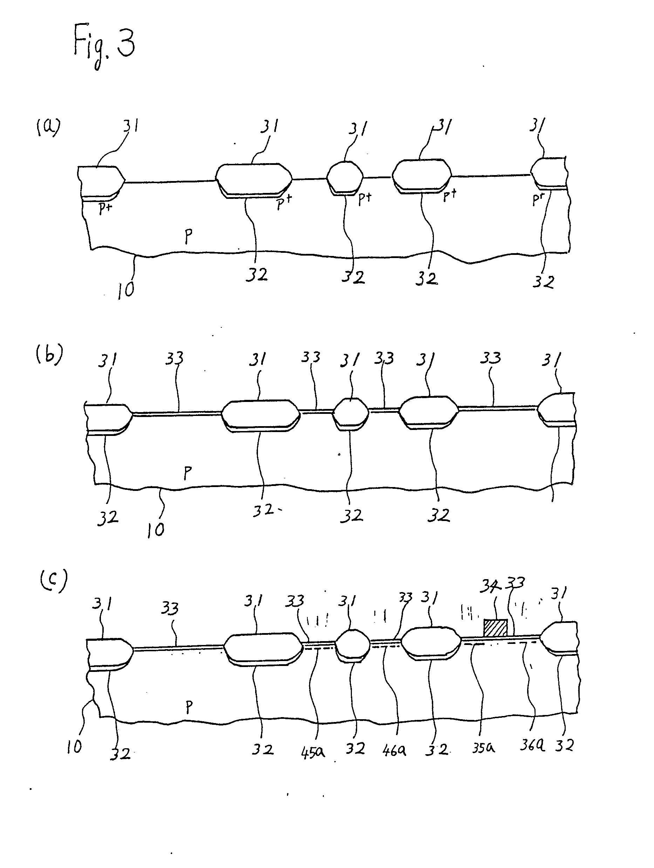

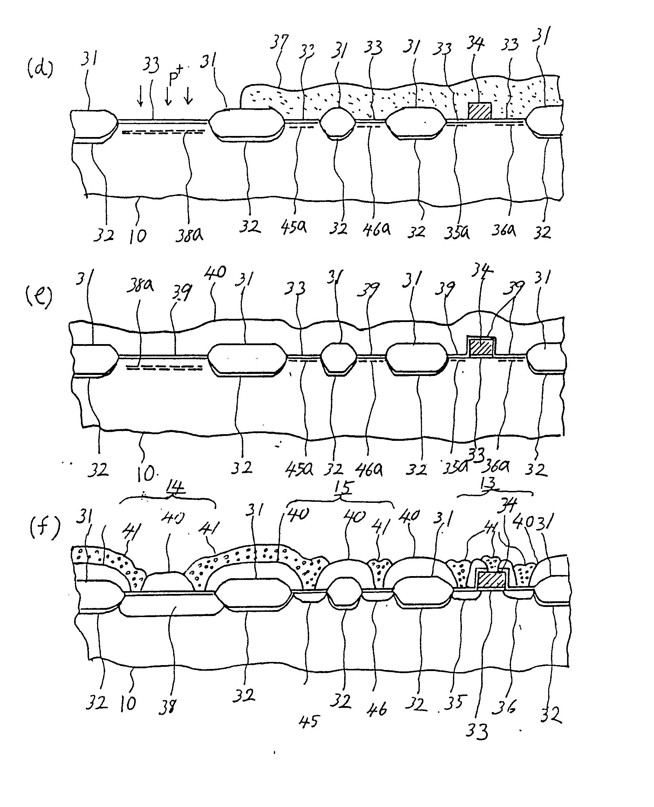

The plan view of an embodiment is illustrated in Fig. 1, and its schematic cross-sectional view is illustrated in Fig. 2. On a p-type silicon substrate 10 having the resistivity of around 20 $\Omega$cm, the inner elements 13 for the input circuit, usually MOS FETs are formed, having shallow diffusion region (source region 35 and drain region 36). Between the input/output terminal 12 and the gate electrode 34 of the inner element 13, an input protection circuit is arranged comprising a first protective element 14 having deep diffusion region 38 and a second protective element 15, a lateral transistor, having shallow diffusion regions, a collector region 45 and an emitter region 46. Comparing with the diffusion region 35 and 36 of the inner element 13, the diffusion region 38 is relatively deeper and the diffusion region 45 and 46 has almost the same depth.

The first protection element 14 has a n-p junction formed by the n-type duffusion region 38 and p-type substrate 10 and act as a diode having a breakdown voltage $V_{b1}$. An interconnecting means for the wiring of the circuit, usually aluminum interconnecting layer 41 is disposed on an insulating layer 40 which is usually a phosphorus silicate glass (PSG) layer, formed on the device.

The second protective element 15 is a n-p-n type lateral transistor comprising separated n-type diffusion regions 45 (for collector) and 46 (for emitter) and p-type substrate 10 (for base). As described before, the first protective element 14 having a deep diffusion region 38 has a high withstanding ability to the breaking down current (energy), but its breakdown voltage $V_{b1}$ is relatively high, and such high voltage can not be applied to the inner element 13 directly. The surge voltage clamped by the first protective element should be reduced below the specified voltage before it is applied to the second protective element 15 which has low surge capacity.

The input/output terminal 12 is connected with the aluminum interconnecting layer 41 to a point 38p of the diffusion region 38. Another point 38g of the diffusion region 38 is connected to the diffusion region 45, the collector of the lateral transistor 15, so as to the resistance of the diffusion region 38 (around 1 KΩ for instance) is inserted between the input/output terminal 12 and the lateral transistor 15. The n-p junction formed by the diffusion region 38 and the substrate 10 has a large parasitic capacity such as 3 pF. The collector 45 is connected to the gate electrode 34 of the MOS FET 13 (connecting path is not shown in Fig. 2 but is shown in Fig. 1); the substrate 10 and the other diffusion region 46 (emitter of the transistor 15) are grounded.

Therefore, the applied surge voltage is clamped to the breakdown voltage $V_{b2}$ of the lateral transistor 15 having shallow diffusion regions when it reaches to the gate electrode 34 of the inner element. The voltage $V_{b2}$ is low enough to prevent the gate insulator 33 of the MOS FET 13 from destruction, but the burn-out energy of the transistor 15 is small and can not withstand the high breakdown energy namely the surge capacity of the transistor 15 is low. This is covered as follows.

The excess input voltage applied to the input/output terminal 12, usually in pulse form, is discharged by the breakdown of the first protective element (diode) 14 having a high surge capacity. The break down voltage $V_{b1}$ of the diode 14 is transferred through C-R network composed of the resistance $R_1$ of the diffusion region 38 and its parasitic capacity $C_1$ to the ground. The transferred voltage and energy is dumped to a lower level $V_2$ and is applied to the second protection element 15, the lateral transistor. If this voltage $V_2$ is higher than the breakdown voltage $V_{b2}$ of the lateral transistor 15, the transistor 15 will break down, but will not be burn out because the transferred energy has been already reduced enough. Of course, the breakdown voltage $V_{b2}$ is selected to a low one enough to protect the gate insulator 33 of the FET 13 from breakdown.

Hereto, a protection circuit for input circuit 11 is described, but apparently this invention is applicable to the one for the output circuit 21.

A first protection element 26 having a deep diffusion region 22, and the second protection element 24, a lateral transistor, having shallow diffusion regions 23 are formed on the substrate 10. The depth of the diffusion region 22 and 23 are selected respectively to be larger and almost equal to or smaller than that of the diffusion region of inner elements in the output circuit (not shown in the figure). The action and effect of the circuit are the same as that of input circuit, so further description will be omitted.

Furthermore, the depth of the diffusion region of the second elements can be selected smaller than that of the inner elements.

Next, the method for fabricating method of input circuit including the protection circuit shown in Fig. 1 will be described referring to figures in Fig. 3. Concrete fabricating steps are shown in the figures (a) to (f). Each of figures illustrates schematically the enlarged partial cross-sectional views.

A p-type monocrystalline silicon substrate 10 has a doping density in the range of approximately $6.5 \times 10^{14}$ atm/cm$^3$. The fabrication begins with the p$^+$ ion-implanting of around $1.2 \times 10^{13}$ atm/cm$^2$ selectively for channel-cut layer 32 in advance. A field oxide layers 31 (silicon dioxide, $SiO_2$) using conventional LOCOS (Local Oxidation of Silicon) is formed. The formation of the field oxide layer 31 is performed by a conventional thermal oxidizing method and a masking pattern of silicon nitride ($Si_3N_4$) film formed using conventional photo-lithographic technology. During this process, the selectively ion-implanted p$^+$ dopant is diffused to form the channel-cut layer 32 of 0.5~0.6 μm in thickness beneath the field oxide layer 31.

After the field oxide layers 31 are grown, as shown in Fig. 3(b), another silicon oxide layer 33 having a thickness of 400~500 Å is formed all over the substrate 10 including the field oxide layer 31. This layer forms the gate oxide layer later as shown in Fig. 3(c). This step is followed by the formation of a conductive polycrystalline silicon layer having a thickness of 4000 to 5000 Å and a sheet resistance of 30 Ω/cm$^2$. This layer is formed by a conventional chemical vapor deposition (CVD) method and is heavily doped with n-type dopant (phosphorus for instance).

Next, the n-type polycrystalline silicon layer is etched off leaving the silicon gate electrode 34 as shown in Fig. 3 (c), using a silicon gate mask being formed by a conventional photo-lithographic technology. The silicon dioxide layer 33 is left for protecting the surface for a while.

Now the formation of the source region 35 and drain region 36 for field effect transistors 13, and collector region 45 and emitter region 46 for lateral transistor 15 will start. These regions are defined by the field oxide layers 31 and gate electrode 34. In the ion-implanting process, the device is exposed to the arsenic ion beam with an accelerating energy of about 120 Kev and a high dose of $4 \times 10^{15}$ atm/cm$^2$ for example. The dopant penetrates through the silicon dioxide layer 33 and into the substrate 10 to form a thin layer of concentrated n$^+$ type dopants of arsenic 35a, 36a, 45a and 46a, being denoted by dotted lines in the figure. The fabricating steps described above are conventional process for the fabrication of an ordinary ICs.

Now the first protective element 14 for the protection circuit, having a deeper impurity diffusion region according to the present invention is started. All the surface of the device is covered by a photo-resist layer 37, and a window is opened on the portion where the first protective element 14 is to be formed using a conventional photo-lithographic technology. As shown in Fig. 3(d), phosphorus ion (P$^+$) of $10^{15}$ atm/cm$^2$ is ion-implanted through the window and the silicon dioxide layer 33 into the substrate 10 and an phosphorus concentrated layer 38a (denoted by a dotted line) is formed.

After that, the photoresist layer 37 is removed and the silicon oxide layer 33, except underneath the gate electrode 34, is etched away and removed. Following this step, a blocking oxide layer 39 of silicon dioxide (SiO$_2$) is newly formed covering the surface of the device. The blocking oxide layer 39 prevents the phosphorus contained in the phosphorus silicate glass (PSG) from diffusing into various diffusion regions such as the source region 35, drain region 36 and so on, in the following steps. On the blocking oxide layer 39, a PSG layer 40 is formed covering the all surface. Windows for the contact holes to every diffusion region already formed, are opened by the conventional photo-lithographic method being followed a heat treatment at around 1050°C in a furnace. The PSG layer is softened (half remelted) at this temperature and the edge of the windows are rounded to prevent the breaking of an interconnecting layer to be formed on the edge. With this heat treatment, the concentrated phosphorus (p$^+$) dopant in the portion 38a is diffused into the substrate 10 to form a diffusion region 38 of about 0.8 µm in depth. At the same time, the concentrated arsenic (As$^+$) dopant is diffused to form the source diffusion region 35 and drain diffusion region 36 of the FET 44, and collector region 45 and emitter region 46 of the lateral transistor 15, namely, the second protective element. Phosphorus has a higher diffusion co-efficient than arsenic in a silicon substrate. So, the diffusion region 38 has a depth of about 0.4 µm, being much shallower than that of the diffusion region 32. Thus the deeper diffusion region 38 has been formed providing the first protective element to be completed later with a high surge capacity for the input voltage. The depth of the diffused region can be controlled by other methods such as the diffusion temperature or the dopant density concentrated beforehand.

After the formation of diffusion regions, as shown in Fig. 3(f), a conducting layer such as an aluminum layer is deposited, being connected to the diffusion regions through windows already formed in PSG layer 40. By a conventional photo-lithographic technology, the conducting layer, the aluminum layer, is patterned to form the specified interconnecting layer 41, and finally a protecting layer of PSG is formed having openings for the input/output bonding pads (not shown in the figures). The detailed description of the fabricating steps after the steps shown in Fig. 3(f), shall be omitted because it is not the focus of this invention.

In the similar way, the fabrication of a protection circuit for the output circuit (shown in Fig. 1 and designated by reference numeral 21) can be formed. In the example described above, the terminal is for output/input use, but the present invention is also applicable to an IC device having input terminal and output terminal separately.

For evaluating the effect of the protection circuit according to the present invention, an experiment was conducted in comparison with the one of the prior art structure.

The conditions and results are shown in the Table 1.

TABLE 1

|  | Prior art one | Improved one |
|---|---|---|
| diffusion region depth of FET | 0.4 μm | 0.4 μm |
| gate insulator thickness of FET | 400 Å | 400 Å |
| breakdown voltage of gate | 30 V (DC) | 30 V (DC) |
| diffusion region depth of (second) protective element | 0.4 μm | 0.4μm |
| breakdown voltage of ditto | 30 V (DC) | 30 V (DC) |
| diffusion region depth of first protective element | none | 0.6~0.7 μm |
| breakdown voltage of ditto | none | 35~36 V (DC) |

The testing energy stored up in a condenser of the capacity 200 pF at various testing voltage (DC), was applied to the input or output terminal of the IC device to be tested. The applied voltage started from a lower voltage; raised gradually until the IC device under test was damaged.

The prior art IC device withstood around 200 volts. While the improved IC device could withstand around 350 volts, proving a remarkable progress in the withstanding ability against the excess input energy. So, it can be concluded that the present invention provides semiconductor devices with much improvement in their reliability in the field.

**Claims**

1. A semiconductor device formed on a semiconductor substrate of a first conductivity type having an input and/or output terminal (12), a protection circuit and an inner element (13), said protection circuit comprising:

a first protective element (14) having a first impurity diffusion region of a second conductivity type opposite to the first conductivity type provided with a first contact point and with a second contact point separated from each other on said first impurity diffusion region so that, in addition to the distributed capacitance C between the first impurity diffusion region and the substrate, a resistor R is formed between said first and second contact points, said capacitance and said resistor forming an RC low pass network connected in series between said terminal (12) and said inner element.

characterised in that it further comprises a second protective element (15) inserted between said second contact point (38 g) and said inner element (13) and having a second impurity diffusion region of the second conductivity type shallower than said first impurity diffusion region, which is made deep enough to provide a higher surge capacity, and equal or shallower than the diffusion regions of the inner element so as to provide a low protection voltage enough to protect said inner element.

2. A semiconductor device according to claim 1, wherein said second protective element (15) is a lateral transistor comprising:

a collector (45) formed of said second impurity diffusion region of said second type conductivity;

an emitter (46) formed of said second impurity diffusion region of said second type conductivity; and a base formed of said substrate (10) of said first conductivity existing between said collector (45) and said emitter (46).

3. A method for forming said first protective element of said semiconductor device according to claim 1, comprising the steps of:

covering all the surface of said semiconductor device with a photo-resist layer (37) after said inner element (13) and said second protective element (15) already being formed;

opening a window in said photo-resist layer (37) on the portion where said first impurity region (38) is to be formed;

implanting impurity ions of said second type conductivity;

diffusing said implanted impurity into said substrate.

**Patentansprüche**

1. Halbleitervorrichtung, die auf einem Halbleitersubstrat von einem ersten Leitfähigkeitstyp gebildet ist und einen Eingangs- und/oder Ausgangsanschluß (12), eine Schutzschaltung und ein inneres Element (13) hat, welche Schutzschaltung umfaßt:

ein erstes Schutzelement (14), das einen ersten Verunreinigungsbereich von einem zweiten Leitfähigkeitstyp, entgegengesetzt zum ersten Leitfähigkeitstyp, hat, mit einem ersten Kontaktpunkt und einem zweiten Kontaktpunkt, die voneinander auf dem genannten ersten Verunreinigungsbereich getrennt sind, so daß, zusätzlich zu der verteilten Kapazität C zwischen dem ersten Verunreinigungsdiffusionsbereich und dem Substrat ein Widerstand R zwischen dem ersten und zweiten Kontaktpunkt gebildet ist, wobei die genannte Kapazität und der genannte Widerstand ein RC-Tiefpassnetzwerk bilden, das in Reihe zwischen dem genannten Anschluß (12) und dem genannten inneren Element verbunden ist,

dadurch gekennzeichnet, daß sie ferner ein zweites Schutzelement (15) umfaßt, das zwischen dem genannten zweiten Kontaktpunkt (38g) und dem genannten inneren Element (13) eingefügt ist und einen zweiten Verunreinigungsdiffusionsbereich von dem zweiten Leitfähigkeitstyp hat, der flacher als der genannte erste Verunreinigungsdiffusionsbereich ist, welcher tief genug hergestellt ist, um eine höhere Schutzkapazität zu bilden, und gleich oder flacher als die Diffusionsbereiche des inneren Elementes, um so eine niedrige Schutzspannung zu liefern, die hinreicht, das genannte innere Element zu schützen.

2. Halbleitervorrichtung nach Anspruch 1, bei welcher das genannte zweite Schutzelement (15) ein lateraler Transistor ist, mit:

einem Kollektor (45), der aus dem genannten zweiten Verunreinigungsbereich von dem genannten zweiten Leitfähigkeitstyp gebildet ist;

einem Emitter (46), der aus dem genannten zweiten Verunreinigungsbereich von dem genannten zweiten Leitfähigkeitstyp gebildet ist; und

einer Basis, die aus dem genannten Substrat (10) von dem genannten ersten Leitfähigkeitstyp gebildet ist und zwischen dem genannten Kollektor (45) und dem genannten Emitter (46) existiert.

3. Verfahren zur Bildung des genannten ersten Schutzelementes der genannten Halbleitervorrichtung nach Anspruch 1, mit den folgenden Schritten:

Bedecken der gesamten Oberfläche der genannten Halbleitervorrichtung mit einer Photoresistschicht (37), nachdem das genannte innere Element (13) und das genannte zweite Schutzelement (15) bereits geformt sind;

öffnen eines Fensters in der genannten Photoresistschicht (37) auf dem Abschnitt, wo der genannte erste Verunreinigungsbereich (38) gebildet werden soll;

Implantieren von Verunreinigungsionen von dem genannten zweiten Leitfähigkeitstyp;

Diffundieren der genannten verunreinigung in das genannte Substrat.

**Revendications**

1. Dispositif à semiconducteur formé sur un susbtrat semiconducteur d'un premier type de conductivité comportant une borne d'entrée et/ou de sortie (12), un circuit de protection et un élément intérieur (13), le circuit de protection comprenant:

un premier élément protecteur (14) comportant une première région de diffusion d'impuretés d'un second type de conductivité opposé au premier type de conductivité pourvue d'un premier point de contact et d'un second point de contact séparés l'un de l'autre sur la première région de diffusion d'impuretés de sorte que, en plus de la capacité répartie C entre la première région de diffusion d'impuretés et le substrat, une résistance R est formée entre les premier et second points de contact, la capacité et la résistance constituant un réseau passe-bas à RC connecté en série entre la borne (12) et l'élément intérieur,

caractérisé en ce qu'il comprend en outre un second élément protecteur (15) inséré entre le second point de contact (38g) et l'élément intérieur (13) et comportant une seconde région de diffusion d'impuretés du second type de conductivité plus superificielle que la première région de diffusion d'impuretés, qui est rendue suffisamment profonde pour fournir une capacité de choc supérieure, et égale aux ou plus superficielle que les régions de diffusion de l'élément intérieur de manière à fournir une faible tension de protection suffisante pour protéger l'élément intérieur.

2. Dispositif à semiconducteur selon la revendication 1, dans lequel le second élément protecteur (15) est un transistor latéral comprenant:

un collecteur (45) constitué par la seconde région de diffusion d'impuretés du second type de conductivité;

un émetteur (46) constitué par la seconde région de diffusion d'impuretés du second type de conductivité; et

une base constituée par le substrat (10) de la première conductivité se trouvant entre le collecteur (45) et l'émetteur (46).

3. Procédé pour former ledit premier élément protecteur du dispositif à semiconducteur selon la revendication 1, consistant à:

recouvrir toute la surface du dispositif à semiconducteur d'une couche photo-résistante (37) après que l'élément intérieur (13) et le second élément protecteur (15) aient déjà été formés;

ouvrir une fenêtre dans la couche photo-résistante (37) dans la partie où la première région à impuretés (38) doit être formée;

implanter des ions d'impuretés du second typ de conductivité;

diffuser les impuretés implantées jusque dans le substrat.

0 130 412

Fig. 1

Fig. 2

# Fig. 3

(a)

(b)

(c)

(d)

31   33  P⁺  31       37  33  31  33  31  33  34  33  31

32  10  38a    32  45a  32  46a  32  35a  36a  32

(e)

31  38a  39  40  31    33  31  39  31  39  34  39  31

32  10    32  45a  32  46a  32  35a  33  36a  32

14          15          13

(f)

31  41  40  41  31  40  40  41  40  31  41  34  40 31

32 10  38    32    32  46  32  35  36  32

45    33